# FASCICULE DE BREVET EUROPEEN

(11) **EP 2 671 115 B1**
(45) Date de publication et mention de la délivrance du brevet: **04.03.2020**
(21) Numéro de dépôt: 12708558.7
(22) Date de dépôt: 30.01.2012
(51) Int. Cl.: G02F 1/1333, G02B 3/00, H01L 31/048, H01L 31/054, G02F 1/1335, G02F 1/133, H01L 31/0468

(54) **DISPOSITIF D'AFFICHAGE AVEC CELLULES PHOTOVOLTAÏQUES INTÉGRÉES, À LUMINOSITÉ AMÉLIORÉE**
ANZEIGEVORRICHTUNG MIT INTEGRIERTEN FOTOVOLTAIK-ZELLEN UND VERBESSERTER HELLIGKEIT
DISPLAY DEVICE WITH INTEGRATED PHOTOVOLTAIC CELLS AND IMPROVED BRIGHTNESS

(30) Priorité: 31.01.2011 FR 1100278; 18.02.2011 FR 1100506
(43) Date de publication de la demande: 11.12.2013
(73) Titulaire: Garmin Switzerland GmbH, 8200 Schaffhausen (CH)
(72) Inventeur: GILBERT, Joël, 13510 Eguilles (FR); CARDI, Philippe, 13850 Greasque (FR); TASSE, Rémy, 1020 Bruxelles (BE)
(74) Mandataire: Bird & Bird LLP
(86) Numéro de dépôt international: PCT/FR2012/000038
(87) Numéro de publication internationale: WO 2012/104503

(56) Documents cités:
- EP-A1- 1 126 337
- US-A1- 2007 102 035
- US-A1- 2010 245 731

## Description

L'invention concerne le domaine des dispositifs d'affichage, et plus particulièrement le domaine des écrans d'affichage rétro-éclairés. De tels écrans comportant un grand nombre de pixels rétro-éclairés sont connus depuis longtemps, et utilisés dans des postes de télévision, des ordinateurs et des dispositifs portables de petite taille, tels que des téléphones mobiles, des consoles de jeux et des calculatrices.
On entend ici par une zone d'image « rétro-éclairée » une zone d'image qui est située devant une source lumineuse qui l'éclaire par l'arrière. La zone d'image peut par exemple être un pixel, une pluralité de pixels ou une partie d'un pixel (par exemple un pixel à cristaux liquides), ou encore un bande de film sur laquelle a été imprimé une image. Dans un écran rétro-éclairé, une source de lumière diffuse est placée derrière le plan des pixels, afin d'améliorer le contraste.
Les dispositifs portables disposent en général d'une alimentation électrique par batteries, dont la durée d'autonomie est un facteur de confort d'utilisation important. Dans le but d'augmenter cette durée d'autonomie, on a intégré des photopiles dans ces dispositifs portables, qui produisent une partie du courant nécessaire au fonctionnement dudit dispositif. Dans la mesure où l'espace disponible pour disposer des photopiles sur la surface externe desdits dispositifs portables est très réduit, il serait souhaitable d'intégrer les photopiles dans l'écran d'affichage.
L'état de la technique montre un certain nombre d'exemples pour une telle intégration. Une première approche consiste à déposer des cellules photovoltaïques semi-transparentes (voir EP 1 174 756 (ETA), US 7,206,044 (Motorola), WO 2009/052326, US 2010/284055, WO 2009/065069 (Qualcomm), US 20101245731 (Intel)). Une autre approche consiste à déposer des couches photovoltaïques sous la forme de bandes entre lesquels passe la lumière provenant des pixels (voir US 2002/0119592 (BP), US 4,795,500 (Sanyo), WO 2009/098459 (M-Solv)). Toutes ces approches conduisent à des écrans qui sont soit peu lumineux, soit la superficie des cellules photovoltaïques, qui est, pour un type de cellule donnée, proportionnelle à l'énergie convertie, est faible.

Le document US 2007/0102035 (X. Yang) montre une autre approche pour une telle intégration, dans laquelle des photopiles couvrant des zones disposées sur la surface de l'écran collectent la lumière diffuse ambiante, alors qu'un système à lentilles disposé derrière l'écran d'affichage focalise la lumière rétro-éclairante sur des zones non recouvertes de photopiles.

Cependant, ces photopiles ne doivent dégrader ni les caractéristiques d'imagerie ni la luminosité de l'écran dans lequel elles ont été intégrées, et c'est pourquoi la surface totale disponible pour ces photopiles est en fait très réduite ; en effet, la largeur des photopiles ne peut pas être significativement supérieure à l'espace entre deux pixels, un espace que l'on souhaite minimiser afin d'améliorer la résolution de l'écran. Si les photopiles sont plus grandes, et *a fortiori* lorsqu'elles recouvrent partiellement la surface des pixels comme c'est le cas dans le mode de réalisation discuté ci-dessus du document US 2007/0102035, la luminosité et la résolution de l'image générée par l'écran se trouvent dégradées. Ce même document comporte un autre mode de réalisation dans lequel la lumière de rétro-éclairage est focalisée dans l'espace entre les photopiles par une lentille située entre la source lumière de rétro-éclairage et le substrat sur lequel se trouve le réseau de pixels ; ce mode de réalisation présente l'inconvénient de nécessiter un positionnement extrêmement précis de la lentille, à la fois en ce qui concerne sa position latérale, mais surtout sa distance par rapport aux photopiles. Par ailleurs, il ne permet pas d'intégrer la source de lumière pour le rétroéclairage directement dans le substrat des transistors à effet de champ qui pilotent les cristaux liquides formant les pixels de l'écran.

La présente invention cherche donc à présenter un écran d'affichage avec cellules photovoltaïques intégrées, qui allie une forte proportion de surface photovoltaïquement active à une forte luminosité de l'affichage, De préférence, cette intégration de cellules photovoltaïques ne nécessite pas de modifications substantielles à la conception de l'écran d'affichage, et notamment de la partie « pilotage des pixels », de manière à pouvoir utiliser des conceptions d'écrans connues.

Dans le cadre de la présente invention, ce problème est résolu par l'association judicieuse de trois éléments essentiels : un réseau de pixels qui génère une image, une pluralité de cellules photovoltaïques, et une pluralité de lentilles formant un réseau lenticulaire, Chacun de ces trois éléments est caractérisé par sa forme, sa dimension et son positionnement par rapport à l'autre, pour former un écran d'affichage digital à cellules photovoltaïques intégrées.

Le premier objet de l'invention est un dispositif d'affichage, en particulier un écran digital d'affichage, à cellules photovoltaïques intégrées, comportant
(a) un réseau de zones d'image émettant de la lumière ou rétro-éclairés par une source de lumière placée derrière le réseau de zones d'images ;
(b) un réseau formé par une pluralité de cellules photovoltaïques et une pluralité d'orifices, dans lequel réseau deux cellules photovoltaïques voisines forment un orifice,
(c) un réseau lenticulaire permettant de focaliser la lumière émise par lesdites zones d'image dans l'orifice entre deux cellules photovoltaïques voisines,
   ledit dispositif étant caractérisé en ce que ledit réseau lenticulaire est positionné entre ledit réseau de zones d'images et ledit réseau de cellules photovoltaïques.

Le dispositif selon l'invention comporte un réseau de zones d'images. Il peut s'agir de pixels. Le terme « pixel » englobe ici soit un pixel individuel de couleur unique, soit une pluralité de parties d'un pixel (typiquement trois, à savoir de couleur bleue, rouge et verte) qui coopèrent afin de créer une tache lumineuse d'une couleur déterminée en fonction de l'intensité émise par chaque zone. Ces zones d'images ou pixels forment un réseau ordonné ; les techniques d'affichage par pixels sont connues de l'homme du métier. L'écran selon l'invention peut être rétro-éclairé au moyen d'une source de lumière placée derrière le réseau de zones d'images ou pixels (par exemple dans le cas d'un écran de type LCD (Liquid Crystal Display) ou dans le cas d'un panneau publicitaire comprenant des zones d'images sous la forme de bandes parallèles imprimées, de préférence translucides), et/ou les pixels peuvent émettre activement de la lumière (par exemple des pixels électroluminescents). L'écran peut être un écran souple ou rigide. Il peut comporter sur sa face externe une couche ou un film tactile, de manière à permettre l'entrée de données par l'utilisateur par l'intermédiaire d'une voie tactile.

Dans d'autres modes de réalisation, les zones d'images, pixels et/ou parties de pixels sont ordonnés de manière à ce que différentes groupes de zones d'images, pixels et/ou parties de pixels génèrent des images différentes.

Le dispositif selon l'invention comprend par ailleurs une pluralité de cellules photovoltaïques qui forment ou contiennent une pluralité d'orifices par lesquelles la lumière en provenance des zones d'image ou des pixels peut passer. Lesdits orifices peuvent avoir une forme quelconque, par exemple rectangulaire ou circulaire. Lesdites cellules peuvent être déposées sur un substrat approprié, par exemple une plaque ou un film ; nous appelons par la suite les cellules photovoltaïques déposées sur leur substrat une « plaque photovoltaïque », ce qui n'implique nullement qu'elle soit mécaniquement rigide. Au contraire, ledit substrat peut être souple, flexible. Lesdites cellules photovoltaïques peuvent avoir une forme quelconque, mais de préférence rectangulaire. Elles peuvent se présenter sous la forme de bandes parallèles qui alternent avec des bandes vides (orifices), i.e. ne comportant pas de cellules photovoltaïques. Ces bandes sont de préférence équidistantes, formant un réseau ordonné. Grâce aux orifices, la plaque photovoltaïque est partiellement transparente ; la transmission optique dite externe (Tₑₓₜ) de la plaque photovoltaïque est déterminée en grande partie par la fraction surfacique qu'occupent les cellules photovoltaïques, et par leur transmission optique intrinsèque.

Lesdites cellules photovoltaïques sont avantageusement des cellules photovoltaïques en couche mince à base de silicium amorphe ou microcristallin, car ce type de cellules est particulièrement adapté pour convertir de la lumière de faible intensité (lumière diffusante, lumière à l'intérieur de pièces) ; mais on peut aussi réaliser ces cellules photovoltaïques en toute autre technologies adaptée, par exemple à base de CdTe ou CIGS (cuivre - indium - gallium - sélénium) ou à base de polymères. Il peut s'agir de jonctions de type pi-n ou p-n, ou encore de cellules tandem, i.e. comportant deux cellules superposées qui absorbent préférentiellement une partie différente du spectre lumineux. Elles peuvent être conçues pour convertir la lumière visible et/ou la lumière ultra-violette et/ou la lumière infrarouge en électricité. Elles peuvent être au moins partiellement transparentes à la lumière visible. Elles peuvent être protégées par une couche de protection, qui est avantageusement pourvue d'une couche antireflets.

Le dispositif selon l'invention comprend également une pluralité de lentilles. On entend ici par « lentille » tout dispositif en matériau transparent, isotrope ou non, ayant la propriété de dévier et/ou concentrer ou diverger les rayons lumineux. Le terme « lentille » comprend ici les prismes. Typiquement cette pluralité de lentilles se présente sous la forme d'un film ou d'une plaque lenticulaire, qui comporte une pluralité de lentilles. Il peut s'agir de lentilles de circonférence circulaires, mais on préfère un réseau lenticulaire comportant une juxtaposition de lentilles rectilignes identiques, dont l'axe longitudinal est parallèle aux bandes de cellules photovoltaïques. Nous appelons ici cette pluralité de lentilles « plaques lenticulaires » ou « réseau lenticulaire », quel que soit son mode de réalisation.

Avantageusement, le plan de la plaque photovoltaïque, le plan du réseau lenticulaire et le plan des pixels sont sensiblement parallèles, mais ces plans peuvent être galbés (tout en restant parallèles), notamment dans le cas où l'écran est un écran souple. Les plaques lenticulaires peuvent être réalisées en une matière plastique transparente appropriée, telle que le PET.

Selon l'invention, la forme des lentilles, leur caractéristiques optiques et leur positionnement par rapport à la plaque photovoltaïque sont tels qu'un faisceau lumineux provenant d'une zone d'image (par exemple d'un pixel ou d'une partie d'un pixel) et traversant une lentille, ce faisceau lumineux aura en sortie de la lentille, typiquement par l'effet d'une déviation et/ou concentration optique, une direction lui permettant de traverser au moins en partie, mais de préférence en totalité, l'orifice entre deux cellules photovoltaïques adjacentes. Si la totalité de l'intensité lumineuse provenant des pixels passe dans les orifices, la transmission optique dite interne (Tᵢₙ) de la plaque photovoltaïque est maximale. Mais le but de l'invention peut être atteint même si une partie de la lumière provenant des pixels est absorbée par la plaque photovoltaïque. Typiquement, à chaque lentille correspond un orifice de forme et taille adéquates. D'une manière générale, les lentilles formant la plaque lenticulaire (et qui sont avantageusement disposées de manière à former un réseau lenticulaire) peuvent avoir toute forme et caractéristique appropriées ; il peut s'agir notamment de lentilles plan-convexes ou biconvexes, ou encore de lentilles sphériques et/ou asphériques, ou encore de lentilles symétriques ou asymétriques, ou encore les lentilles à variation d'indice.

Plus particulièrement, le réseau de zones d'images est avantageusement positionné par rapport à la plaque lenticulaire et par rapport à la plaque photovoltaïque de manière à ce que la lumière provenant de chaque zone d'image ou partie de zone d'image et reçue par la lentille correspondante de la plaque lenticulaire soit déviée et/ou concentrée par cette lentille de manière à passer entièrement, ou au moins en grande partie, au travers de l'un des orifices de la plaque photovoltaïque.

Dans un mode de réalisation avantageux, ledit réseau lenticulaire comporte une juxtaposition de lentilles rectilignes identiques, dont l'axe longitudinal est parallèle aux bandes de cellules photovoltaïques.

Pour éviter les réflexions parasites au passage de la plaque lenticulaire vers la plaque photovoltaïque et réciproquement, les deux plaques peuvent être collées ou peuvent ne constituer qu'une seule plaque comportant à la fois les cellules photovoltaïques et les lentilles.

D'une manière générale, pour éliminer au moins en partie la réflexion de la lumière ambiante à la surface de la plaque photovoltaïque, celle-ci pourra comporter au moins une couche antireflet. Ce terme englobe ici un revêtement spécifique ou un traitement de surface de ladite plaque photovoltaïque, ou encore une micro-structuration optique de la surface, ou encore un revêtement multicouches comportant des couches d'indices de réfraction différents.

Le dispositif selon l'invention présente de manière préférée une transmission interne de la plaque photovoltaïque (Tᵢₙ) élevée, et une transmission externe (Tₑₓₜ) faible, ce qui est obtenu grâce à la plaque lenticulaire judicieusement choisie et positionnée, comme indiqué ci-dessus. Ainsi, on obtient en même temps une image bien résolue et lumineuse et une importante conversion photovoltaïque de la lumière externe. En revanche, en l'absence de la plaque lenticulaire, les deux transmissions Tᵢₙ et Tₑₓₜ sont du même ordre de grandeur, et la qualité de l'image va au détriment de la conversion photovoltaïque.

Un autre objet de l'invention est un ensemble constitué par une plaque photovoltaïque et un réseau lenticulaire associé qui peut être apposé sur un écran digital d'affichage pour former un écran digital d'affichage à cellules photovoltaïques intégrées, comme précédemment décrit. Plus particulièrement, l'ensemble peut être constitué d'un substrat ou film transparent, de préférence souple ou semi-rigide, typiquement en matériau polymère, sur lequel a été déposé ledit réseau lenticulaire, et sur lequel a été déposé un réseau de cellules photovoltaïques. Cer dernières sont éventuellement protégées, comme indiqué ci-dessus, par une couche de protection, par exemple un dépôt de surface (couche mince) ou un film souple. Ladite couche de protection peut être continue ou discontinue. Cet ensemble, que nous appelons ici « film (ou plaque) photovoltaïque à lentilles intégrées », peut être apposé et fixé, par exemple par collage, sur la surface externe d'un écran digital d'affichage. Cette surface externe est de préférence lisse ; elle peut être plate ou galbée, rigide ou souple. Ce film ou plaque photovoltaïque à cellules photovoltaïques intégrées comprend également les électrodes, typiquement en couche mince, nécessaires pour connecter les cellules photovoltaïques entre elles et pour collecter le courant.

Un autre objet de l'invention est un procédé de fabrication d'un écran digital d'affichage en utilisant la plaque photovoltaïque à lentilles intégrées selon l'invention, qui comprend les étapes suivantes : on approvisionne un écran digital d'affichage comportant une surface externe lisse, on approvisionne une plaque photovoltaïque à lentilles intégrées selon l'invention, et on appose et fixe, de préférence par collage, ladite plaque photovoltaïque à lentilles intégrées sur ledit écran digital d'affichage pour former un écran digital d'affichage à cellules photovoltaïques intégrées. Après l'apposition de la plaque photovoltaïque sur la surface externe de l'écran, on établit une connexion électrique entre les électrodes de la plaque photovoltaïque à lentilles intégrées et un élément d'alimentation électrique de l'écran, afin que l'énergie électrique générée par les cellules photovoltaïques puisse contribuer à alimenter en électricité l'appareil électronique portable ou fixe dans lequel ledit écran est intégré ; cette alimentation peut se faire directement ou indirectement (en chargeant un moyen de stockage d'énergie électrique, tel qu'une pile rechargeable ou un condensateur).

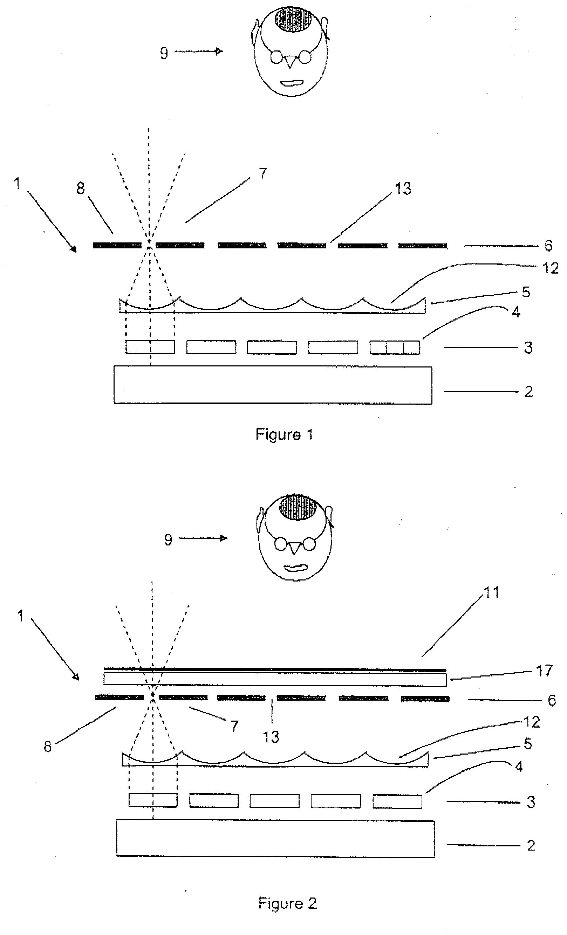

Les figures 1 à 9 illustrent de manière schématique des modes de réalisation de l'invention, mais ne limitent pas l'invention. Il est entendu que tous les modes de réalisation et toutes les variantes présenté(e)s peuvent être combinés entre eux et/ou entre elles. Ces figures ne montrent pas certains composants indispensables au fonctionnement d'un écran d'affichage mais bien connus de l'homme du métier, notamment la couche de transistors à effet de champ qui est essentielle pour générer une image dans un écran à cristaux liquides.

La figure 1 montre de manière schématique un premier mode de réalisation de l'invention. La figure représente une coupe transversale à travers un écran d'affichage selon l'invention. L'écran d'affichage **1** selon l'invention comporte un réseau **3** de zones d'images **4** (qui peuvent être des pixels) rétro-éclairés par une source de lumière **2**, typiquement plate, placée derrière le réseau **3** de zones d'images **4.** La source de lumière **2** plate peut être une plaque diffusante. Dans une variante de ces modes de réalisation, le réseau **3** de pixels **4** n'est pas rétro-éclairé par une source de lumière **2**, mais chaque pixel **4** constitue lui-même une source de lumière, par exemple par électroluminescence. Comme indiqué ci-dessus, chaque pixel **4** peut être formé par une pluralité d'unités de couleur différente, typiquement par trois unités (rouge, bleu, vert). Cela est illustré sur la figure 1 et s'applique à tous les modes de réalisation de la présente invention.

L'écran **1** selon l'invention comporte également un réseau **6** de bandes de cellules photovoltaïques **7,8**; la figure ne montre pas le substrat sur lequel elles ont été déposées. L'écran **1** comporte également un réseau lenticulaire **5** qui comporte une juxtaposition de lentilles rectilignes identiques, dont l'axe longitudinal est parallèle aux bandes de cellules photovoltaïques **7,8**. Ledit réseau lenticulaire est positionné entre ledit réseau **3** de zones d'images **4** et ledit réseau **6** de cellules photovoltaïques **7,8.** Le réseau lenticulaire **5** peut être constitué d'une juxtaposition de lentilles **12** rectilignes ou autres, identiques, qui peuvent être de type plan-convexe ou biconvexe, ou autre ; elles peuvent être de type symétrique ou asymétrique, sphérique ou asphérique. Avantageusement, ledit réseau lenticulaire **5** génère un effet de lentille individuelle pour chaque pixel **4,** focalisant la lumière provenant du pixel **4** dans l'orifice **13.**

Comme représenté par le faisceau en trait interrompu, le faisceau lumineux en provenance d'un pixel **4** est concentré par une lentille correspondante du réseau lenticulaire, de manière à être dirigé aussi précisément que possible à travers un orifice 13 correspondant du réseau photovoltaïque 6. Comme expliqué plus loin, dans le cas où une partie du faisceau lumineux émis par le pixel **4** subit des réflexions parasites l'empêchant de passer au travers d'un orifice, la qualité de l'image perçue par l'observateur 9 pourrait être quelque peu diminuée, mais il sera possible de récupérer l'énergie lumineuse diffusive non transmise pour générer un complément d'énergie photovoltaïque à partir de cellules photovoltaïques disposées sur la face interne de la plaque photovoltaïque, orientée vers les pixels **4.**

D'une manière générale, les pixels ou zones d'images **4** n'ont pas besoin d'être toutes dans le même plan, mais ils peuvent être disposés sur plusieurs plans sensiblement parallèles. Les pixels **4** peuvent être subdivisés en cellules, pour un affichage couleur, selon les technologies connues de l'homme du métier, par exemple chaque pixel peut être subdivisé en trois cellules de couleur rouge, verte et bleue.

Dans tous les modes de réalisation de l'invention, les cellules photovoltaïques **7** peuvent utiliser toute technologie en couches minces connue et appropriée. Pour des écrans destinés aux dispositifs utilisés à l'intérieur, il est préférable d'utiliser des cellules qui ont une bonne efficacité de conversion à faible luminosité (par exemple des cellules à base de silicium amorphe ou microcristallin), car lesdites cellules capteront principalement de la lumière diffusante.

Dans tous les modes de réalisation de l'invention, l'écran **1** selon l'invention peut comprendre d'autres composants qui améliorent ses caractéristiques ou qui les adaptent à certaines situations d'utilisation particulières. A titre d'exemple, il peut comprendre également un ou plusieurs de éléments suivants : un filtre de couleur, un filtre de polarisation, un élément lenticulaire, un diffuseur de lumière, une couche protectrice. L'écran **1** peut aussi être un écran souple.

La figure 2 montre de manière schématique une variante de ce premier mode de réalisation, pouvant être combiné avec tous les autres modes de réalisation de l'invention, dans lequel le réseau **6** de bandes photovoltaïques est protégé par une couche de protection **17** qui peut être rigide ou souple, continue ou discontinue ; par exemple, il peut s'agir d'un film polymère. Cette couche peut comporter une couche antireflet **11**, avantageusement sur la face externe (i.e. la face tournée vers l'observateur **9**). Ladite couche de protection **17** peut former le substrat sur lequel a été déposé ledit réseau **6** de bandes de cellules photovoltaïques **7,8.**

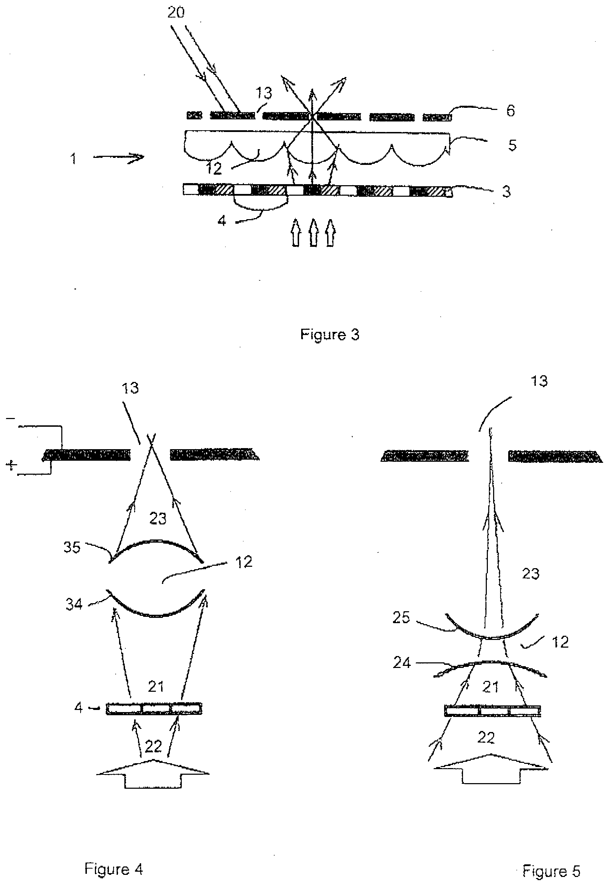

La figure 3 montre de manière schématique et simplifiée une autre représentation d'un mode de réalisation similaire. Le réseau de pixels **3** est rétro-éclairé (flèches blanches), la source de lumière n'est pas montrée sur cette figure. Les chemins optiques des faisceaux provenant de chacune des trois zones des pixels **4** sont clarifiés.

La figure 4 montre de manière schématique et simplifiée un autre mode de réalisation particulier dans lequel le faisceau lumineux **21** en provenance de la zone d'image **4** est divergent ; cela peut être réalisé par exemple avec un pixel **4** de type LCD rétro-éclairé par un faisceau de lumière **22** divergent (comme montré sur la figure 4), ou par un pixel électroluminescent de type LED ou OLED (variante non montrée sur la figure). Dans ce cas la lentille **12** correspondante est avantageusement convergente avec une première face convexe **34** et au besoin une deuxième face convexe **35**, de manière à réduire la longueur focale de la lentille **12** et obtenir ainsi un faisceau de lumière **23** convergent et focalisé sur l'orifice **13** après son passage au travers de la lentille **12** et/ou augmenter l'angle de sortie du faisceau lumineux sortant.

Dans un autre mode de réalisation montré de manière schématique et simplifiée sur la figure 5, le faisceau lumineux **21** en provenance du pixel **4** est convergent ; cela peut être réalisé par exemple avec un pixel **4** de type LCD rétro-éclairé par un faisceau de lumière **22** convergent. La lentille correspondante **12** peut alors être divergente, avec une première face concave **24** et au besoin une deuxième face concave **25** de manière à augmenter la longueur focale de la lentille **12** et obtenir ainsi un faisceau de lumière **23** convergent et focalisé sur l'orifice **13** et dont le plan focal aura été décalé en s'éloignant du pixel. Ce besoin pourra se présenter par exemple pour augmenter l'épaisseur globale de la plaque lenticulaire et/ou réduire l'angle de sortie du faisceau lumineux.

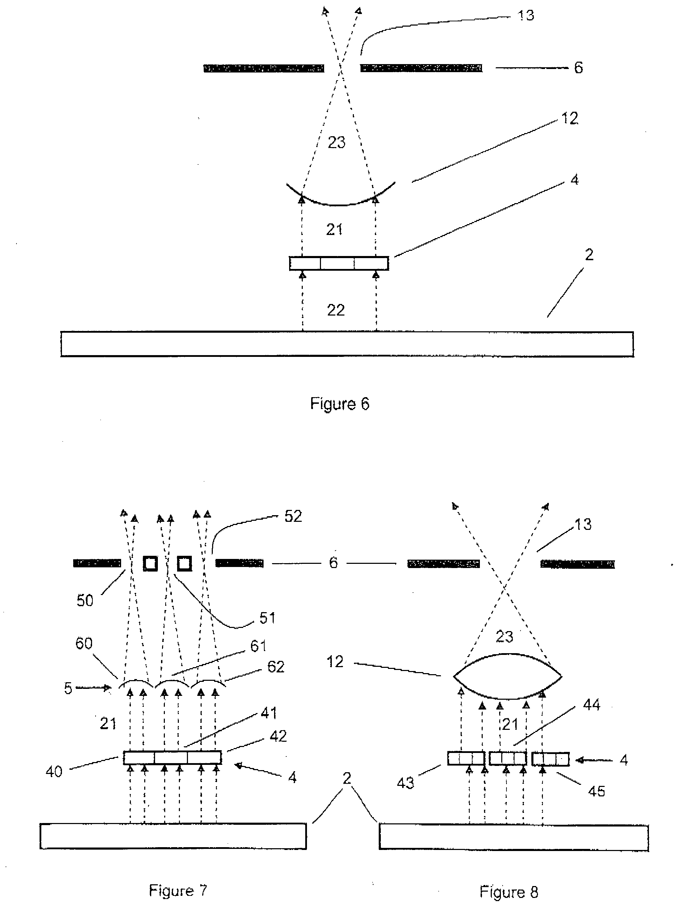

Dans un autre mode de réalisation montré de manière schématique et simplifiée sur la figure 6, le faisceau lumineux **21** en provenance de la zone d'image **4** est parallèle ; cela peut être réalisé par exemple avec un pixel de type LCD rétro-éclairé par un faisceau de lumière **22** parallèle. Dans ce cas la lentille **12** correspondante peut être convergente, avec une face convexe de manière à créer une convergence du faisceau lumineux en un plan focal proche de l'orifice **13** correspondant de la plaque photovoltaïque **6.**

Dans encore un autre mode de réalisation montré de manière schématique et simplifiée sur la figure 7, les orifices **50,51,52** de la plaque photovoltaïque **6** et les lentilles **60,61,62** de la plaque lenticulaire **5** sont en correspondance avec la lumière émise par une partie **40,41,42** seulement du pixel **4.** Cette partie **40,41,42** du pixel **4** peut correspondre par exemple à une zone particulière, correspondant à une des couleurs rouge, verte ou bleu d'un pixel LCD ; sa lumière est déviée par la lentille **60,61,62** correspondante pour être focalisé chacun dans un orifice **50,51,52** correspondant,

Dans encore un autre mode de réalisation montré de manière schématique et simplifiée sur la figure 8, à chaque lentille **12** correspond un groupe de pixels **43,44,45** dont l'ensemble des faisceaux lumineux sortants sont déviés par une lentille **12** associée à ce groupe de pixels **43,44,45** qui les focalise dans l'orifice **13**.

Dans tous les modes dé réalisation, il n'est pas strictement nécessaire que la focalisation de la lumière en provenance des pixels **4,43,44,45** ou parties **40,41,42** de pixels se fasse dans l'orifice **13,50,51,52,** mais la focalisation dans l'orifice donne la meilleure luminosité et qualité de l'affichage.

La plaque photovoltaïque **6** comprend toujours les électrodes, typiquement en couche mince, nécessaires pour connecter les cellules photovoltaïques entre elles et pour collecter le courant (non montré sur les figures).

Dans un mode de réalisation particulier, non illustré par une figure, le dispositif **1** selon l'invention comporte deux ensembles de cellules photovoltaïques différents, l'un dédié à la conversion photovoltaïque de la lumière ambiante **20** (appelée ici « lumière externe »), et l'autre dédié à la conversion photovoltaïque de la lumière diffusive en provenance des pixels et/ou de leur rétro-éclairage (appelée ici « lumière interne »). Par exemple, on peut disposer un premier ensemble de cellules photovoltaïques sur la face externe de la plaque photovoltaïque (de préférence alors protégée par une couche ou un film de protection), destiné à convertir la lumière externe, et un deuxième ensemble de cellules photovoltaïques sur la face interne de la plaque photovoltaïque, destinée à convertir la lumière interne.

L'écran digital d'affichage 1 selon l'invention peut être incorporé dans un appareil électronique fixe ou portable ; cet appareil forme un autre objet de l'invention. Il peut s'agir en particulier d'un téléphone portable, d'un livre électronique, d'un écran de télévision portable, d'un écran d'ordinateur portable. Il peut s'agir également d'appareils fixes de taille plus importante, par exemple d'un écran de télévision fixe ou d'affichage publicitaire. L'écran digital d'affichage 1 selon l'invention peut comporter un film ou un revêtement tactile, c'est-à-dire sensible au toucher, de manière à obtenir un écran tactile.

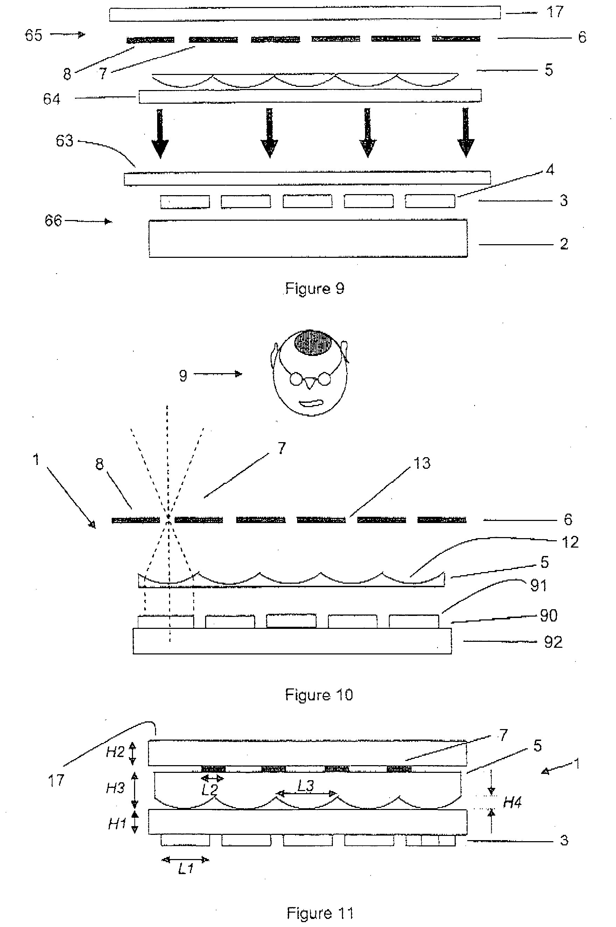

La figure 9 montre de manière schématique le procédé de fabrication d'un écran d'affichage **1** avec cellules photovoltaïques intégrées selon l'invention : La plaque photovoltaïque, comportant le réseau **6** de cellules photovoltaïques (typiquement des bandes photovoltaïques) qui sont éventuellement recouvertes par une couche de protection **17** (elle-même éventuellement recouverte d'une couche antireflet **11**), associée au réseau lenticulaire **5** (éventuellement déposé directement sur ce réseau lenticulaire ou séparée par une plaque ou un film, non montré sur la figure) forme une plaque photovoltaïque à lentilles intégrées ensemble **65** qui peut être apposée sur un écran digital d'affichage **66** pour former un écran digital d'affichage **1** à cellules photovoltaïques intégrées comme précédemment décrit. Plus particulièrement, ladite plaque photovoltaïque à lentilles intégrées **65** peut être constituée d'un film transparent **64**, de préférence souple ou semi-rigide, typiquement en matériau polymère, sur lequel a été déposé ledit réseau lenticulaire **5**, sur lequel a été déposé ledit réseau **6** de cellules photovoltaïques **7,8** sur au moins une de leurs faces, ces dernières éventuellement protégées, comme indiqué ci-dessus, par une couche de protection **17**, par exemple un dépôt de surface (couche mince) ou un film souple.
Cette plaque photovoltaïque à lentilles intégrées **65** peut être apposée et fixée, par exemple par collage, sur la surface externe **63** d'un écran digital d'affichage **66**, comme indiqué par des flèches sur la figure 9. Cette surface externe **63** est de préférence lisse ; elle peut être plate ou galbée, rigide ou souple. Ce film photovoltaïque à lentilles intégrées **65** comprend également les électrodes, typiquement en couche mince, nécessaires pour connecter les cellules photovoltaïques entre elles et pour collecter le courant (non montré sur les figures),

La figure 10 montre encore un autre mode de réalisation de l'invention. Le dispositif d'affichage **1** comporte un réseau **90** des zones d'images **91**, qui sont typiquement déposées ou imprimées sur un substrat **92** et rétro-éclairées. Ledit substrat **92** est avantageusement transparent ou au moins translucide ; il peut être une source de lumière plate. Les zones d'images **91** peuvent former des bandes parallèles, dont le sens long est parallèle à celui des lentilles **12** formant le réseau lenticulaire **5.** Comme dans les autres modes de réalisation, le réseau lenticulaire **5** focalise la lumière en provenance des zones d'image. Ce mode de réalisation convient particulièrement bien pour des dispositifs d'affichage de grande taille présentant des images fixes, par exemple des affiches publicitaires, des enseignes, des plaques décoratives disposées à l'extérieur ou à l'intérieur de bâtiments.

La figure 11 montre de manière schématique un exemple d'une plaque photovoltaïque à lentilles intégrées selon l'invention qui a été réalisée de la manière suivante : on a déposé sur un substrat souple **17** en verre d'une épaisseur *H2* d'environ 500 µm recouvert d'une couche conductrice et transparente de ZnO₂ une cellule photovoltaïque de type p-i-n à base de silicium amorphe hydrogéné, sur la quelle on a ensuite déposé une couche de ITO. Cette cellule photovoltaïque produit une tension en circuit ouvert d'environ 8 V. Par gravure humide à l'acide de la couche ITO, puis par une gravure ionique réactive (RIE - Reactive Ion Etching) dans un plasma formé à partir d'une atmosphère de SF₆ pour le silicium, on a découpé des bandes parallèles dans cette cellule photovoltaïque, pour obtenir un réseau de bandes photovoltaïques **6**.
On a utilisé une plaque lenticulaire **5** en PET d'une épaisseur *H3* d'environ 125 µm avec des lentilles cylindriques d'un pas *L3* de 91 µm, d'une hauteur *H4* d'environ 26 µm et un angle d'ouverture de 120° commercialisée par la société Microsharp.
On a assemblé la plaque photovoltaïque et la plaque lenticulaire pour former une plaque photovoltaïque à lentilles intégrées. Cette plaque, dune dimension d'environ 4,2 cm x 3,7 cm, a été collée sur l'écran d'un téléphone portable de type SGH-F490 commercialisé par la société Samsung, pourvu d'une plaque en verre d'une épaisseur *H1* d'environ 700 µm derrière laquelle se trouve le réseau **3** de pixels d'une largeur individuelle *L1* d'environ 160 µm. On a établi une liaison électrique entre la plaque photovoltaïque et le circuit d'alimentation électrique du téléphone de manière à permettre la recharge de la batterie par la plaque photovoltaïque.

**Liste des repères :**

| | | | |
|---|---|---|---|
| 1 | Dispositif d'affichage | 21,22,23 | Faisceau de lumière |
| 2 | Source de lumière | 24,25 | 1^{ére} et 2^{ème} face concave |
| 3 | Réseau de zones d'image | 34,35 | 1^{ére} et 2^{ème} face convexe |
| 4 | Zone d'image | 40,41,42 | Partie d'une zone d'image |
| 5 | Réseau lenticulaire | 43,44,45 | Groupe de zones d'image |
| 6 | Réseau de cellules photovoltaïques | 50,51,52 | Orifices |
| 7,8 | Cellules photovoltaïques | 60,61,62 | Lentilles |
| 9 | Observateur | 63 | Surface externe |
| 11 | Couche antireflet | 64 | Film transparent |
| 12 | Lentille | 65 | Plaque photovoltaïque à lentilles |
| 13 | Orifice | | intégrées |
| 17 | Couche de protection | 66 | Ecran d'affichage digital |
| 20 | Lumière externe | | |

## Revendications

1. Dispositif d'affichage (1), à cellules photovoltaïques intégrées, comportant :
(a) un réseau (3) de zones d'image (4) émettant de la lumière ou rétro-éclairées par une source de lumière (2) placée derrière le réseau (3) de zones d'images (4) ;
(b) un réseau (6) formé par une pluralité de cellules photovoltaïques (7,8) et une pluralité d'orifices (13) formés entre deux cellules photovoltaïques voisines dudit réseau (6),
(c) un réseau lenticulaire (5) permettant de focaliser la lumière émise par lesdites zones d'image (4) dans l'orifice (13) entre deux cellules photovoltaïques (7,8) voisines,
ledit dispositif (1) étant **caractérisé en ce que** ledit réseau lenticulaire (5) est positionné entre ledit réseau (3) de zones d'images (4) et ledit réseau (6) de cellules photovoltaïques (7,8).

2. Dispositif d'affichage (1) selon la revendication 1, **caractérisé en ce qu'**il s'agit d'un écran digital d'affichage.

3. Dispositif d'affichage selon la revendication 2, **caractérisé en ce qu'**il s'agit d'un écran souple.

4. Dispositif d'image (1) selon l'une quelconque des revendications 1 à 3, **caractérisé en ce que** lesdites zones d'images (4) sont des pixels.

5. Dispositif d'affichage (1) selon l'une quelconque des revendications 1 à 4, **caractérisé en ce que** ledit réseau lenticulaire (5) comporte une juxtaposition de lentilles rectilignes identiques, dont l'axe longitudinal est parallèle aux bandes de cellules photovoltaïques (7,8).

6. Dispositif d'affichage (1) selon l'une quelconque des revendications 1 à 5, **caractérisé en ce que** les lentilles dudit réseau lenticulaire (5) sont sélectionnées dans le groupe formé par les lentilles plan-convexes, biconvexes, symétriques, asymétriques, sphériques et/ou asphériques, ou par les lentilles à variation d'indice.

7. Dispositif d'affichage (1) selon l'une quelconque des revendications 1 à 6, **caractérisé en ce que** ledit réseau (6) de bandes de cellules photovoltaïques (7,8) est protégé par une couche de protection (17), avantageusement pourvue d'une couche antireflets (11).

8. Dispositif d'affichage (1) selon l'une quelconque des revendications 1 à 7, **caractérisé en ce que** lesdites cellules photovoltaïques (7,8) sont des cellules en couche mince â base de silicium amorphe ou microcristallin, à base de CdTe ou à base de CIGS.

9. Dispositif d'affichage (1) selon l'une quelconque des revendications 1 à 8, **caractérisé en ce que** lesdites cellules photovoltaïques (7,8) sont au moins partiellement transparentes à la lumière visible.

10. Dispositif d'affichage (1) selon l'une quelconque des revendications 1 à 9, **caractérisé en ce que** lesdites zones d'images (4), pixels et/ou parties de pixels sont ordonnés de manière à ce que différents groupes de zones d'images, pixels et/ou parties de pixels génèrent des images différentes.

11. Dispositif d'affichage (1), selon l'une quelconque des revendications 1 à 10, **caractérisé en ce qu'**il comporte sur sa face externe une couche ou un film tactile.

12. Dispositif d'affichage (1) selon l'une quelconque des revendications 1 à 11, **caractérisé en ce qu'**il comporte deux ensembles de cellules photovoltaïques différents, l'un dédié à la conversion photovoltaïque de la lumière ambiante ou externe (20), et l'autre dédié à la conversion photovoltaïque de la lumière diffusive ou interne en provenance des pixels et/ou de leur rétro-éclairage.

13. Dispositif d'affichage (1) selon la revendication 12, **caractérisé en ce qu'**il comporte un premier ensemble de cellules photovoltaïques disposées sur la face externe de la plaque photovoltaïque et destinées à convertir la lumière externe, et un deuxième ensemble de cellules photovoltaïques disposées sur la face interne de la plaque photovoltaïque, et destinées à convertir la lumière interne.

14. Appareil électronique portable ou fixe incorporant un dispositif d'affichage (1) selon l'une quelconque des revendications 1 à 13.

15. Plaque photovoltaïque à lentilles intégrée (60) pour la fabrication d'un dispositif d'affichage (1) selon l'une quelconque des revendications 1 à 13, comprenant un substrat ou film (62) transparent, de préférence souple ou semi-rigide, ledit film comprenant un réseau lenticulaire (11), et ledit film comprenant un réseau (5) de cellules photovoltaïques (7,8), lesdites cellules photovoltaïques (7) étant de préférence protégées par au moins une couche de protection (17), continue ou discontinue.

16. Procédé de fabrication d'un dispositif d'affichage (1) à cellules photovoltaïques intégrées selon l'une des revendications 1 à 13, dans lequel on approvisionne un écran digital d'affichage (66) comportant une surface externe (63) lisse, et dans lequel on approvisionne une plaque photovoltaïque à lentilles intégrées (65) selon la revendication 15, et dans lequel on fixe, de préférence par collage, ledit film photovoltaïque à lentilles intégrées (65) sur ledit écran digital d'affichage (66) pour former un écran digital d'affichage (1) à cellules photovoltaïques intégrées.

## Patentansprüche

1. Anzeigevorrichtung (1) mit integrierten photovoltaischen Zellen, umfassend:
(a) ein Netz (3) von Bildbereichen (4), die das Licht ausgeben oder durch eine Lichtquelle (2) hinterleuchtet sind, die hinter dem Netz (3) von Bildbereichen (4) angeordnet ist;
(b) ein Netz (6), das durch eine Vielzahl von photovoltaischen Zellen (7, 8) und eine Vielzahl von Öffnungen (13) gebildet ist, die zwischen zwei benachbarten photovoltaischen Zellen des Netzes (6) gebildet sind,
(c) ein Linsennetz (5), das das Fokussieren des von den Bildbereichen (4) ausgegebenen Lichts in die Öffnung (13) zwischen zwei benachbarten photovoltaischen Zellen (7, 8) ermöglicht,
wobei die Vorrichtung (1) **dadurch gekennzeichnet ist, dass** das Linsennetz (5) zwischen dem Netz (3) von Bildbereichen (4) und dem Netz (6) von photovoltaischen Zellen (7, 8) angeordnet ist.

2. Anzeigevorrichtung (1) nach Anspruch 1, **dadurch gekennzeichnet, dass** es sich um einen digitalen Anzeige-Bildschirm handelt.

3. Anzeigevorrichtung nach Anspruch 2, **dadurch gekennzeichnet, dass** es sich um einen flexiblen Bildschirm handelt.

4. Bildvorrichtung (1) nach irgendeinem der Ansprüche 1 bis 3, **dadurch gekennzeichnet, dass** die Bildbereiche (4) Pixel sind.

5. Anzeigevorrichtung (1) nach irgendeinem der Ansprüche 1 bis 4, **dadurch gekennzeichnet, dass** das Linsennetz (5) eine Aneinanderreihung von identischen rechteckigen Linsen aufweist, deren Längsachse zu den Bändern von photovoltaischen Zellen (7, 8) parallel ist.

6. Anzeigevorrichtung (1) nach irgendeinem der Ansprüche 1 bis 5, **dadurch gekennzeichnet, dass** die Linsen des Linsennetzes (5) aus der Gruppe ausgewählt sind, die durch plankonvexe, bikonvexe, symmetrische, asymmetrische, sphärische und/oder asphärische Linsen oder durch Linsen mit Indexvariation gebildet ist.

7. Anzeigevorrichtung (1) nach irgendeinem der Ansprüche 1 bis 6, **dadurch gekennzeichnet, dass** das Netz (6) von photovoltaischen Bändern (7, 8) durch eine Schutzschicht (17) geschützt ist, die vorteilhaft mit einer Antireflex-Schicht (11) versehen ist.

8. Anzeigevorrichtung (1) nach irgendeinem der Ansprüche 1 bis 7, **dadurch gekennzeichnet, dass** die photovoltaischen Zellen (7, 8) Dünnschichtzellen auf Basis von amorphem oder mikrokristallinem Silizium, auf Basis von CdTe oder auf Basis von CIGS sind.

9. Anzeigevorrichtung (1) nach irgendeinem der Ansprüche 1 bis 8, **dadurch gekennzeichnet, dass** die photovoltaischen Zellen (7, 8) wenigstens teilweise für das sichtbare Licht transparent sind.

10. Anzeigevorrichtung (1) nach irgendeinem der Ansprüche 1 bis 9, **dadurch gekennzeichnet, dass** die Bildbereiche (4), Pixel und/oder Pixelteile derart geordnet sind, dass unterschiedliche Gruppen von Bildbereichen, Pixeln und/oder Pixelteilen unterschiedliche Bilder erzeugen.

11. Anzeigevorrichtung (1) nach irgendeinem der Ansprüche 1 bis 10, **dadurch gekennzeichnet, dass** sie auf ihrer Außenseite eine berührungsempfindlichen Schicht oder einen berührungsempfindlichen Film aufweist.

12. Anzeigevorrichtung (1) nach irgendeinem der Ansprüche 1 bis 11, **dadurch gekennzeichnet, dass** sie zwei unterschiedliche Gruppen von photovoltaischen Zellen aufweist, von denen eine für die photovoltaische Umwandlung des Umgebungs- oder externen Lichts (20) bestimmt ist und die andere zur photovoltaischen Umwandlung des diffusen oder internen, aus den Pixeln oder ihrer Hinterleuchtung stammenden Lichts bestimmt ist.

13. Anzeigevorrichtung (1) nach Anspruch 12, **dadurch gekennzeichnet, dass** sie eine erste Gruppe von photovoltaischen Zellen, die auf der Außenseite der photovoltaischen Platte angeordnet und dazu bestimmt sind, das externe Licht umzuwandeln, und eine zweite Gruppe von photovoltaischen Zellen aufweist, die auf der Innenseite der photovoltaischen Platte angeordnet sind und zum Umwandeln des internen Lichts bestimmt sind.

14. Tragbares oder festes elektronisches Gerät, das eine Anzeigevorrichtung (1) nach irgendeinem der Ansprüche 1 bis 13 aufweist.

15. Photovoltaische Platte mit integrierten Linsen (60) für die Herstellung einer Anzeigevorrichtung (1) nach irgendeinem der Ansprüche 1 bis 13, umfassend ein transparentes Substrat oder einen transparenten Film (62), das/der bevorzugt flexible oder halbsteif ist, wobei der Film ein Linsennetz (11) aufweist und der Film ein Netz (5) von photovoltaischen Zellen (7, 8) aufweist, wobei die photovoltaischen Zellen (7) bevorzugt durch wenigstens eine durchgehende oder unterbrochene Schutzschicht (17) geschützt sind.

16. Verfahren zur Herstellung einer Anzeigevorrichtung (1) mit integrierten photovoltaischen Zellen nach irgendeinem der Ansprüche 1 bis 13, bei dem ein digitaler Anzeige-Bildschirm (66) bereitgestellt wird, der eine glatte Außenfläche (63) aufweist, und bei dem eine photovoltaische Platte mit integrierten (65) Linsen nach Anspruch 15 bereitgestellt wird und bei dem der photovoltaische Film mit integrierten Linsen (65), bevorzugt durch Kleben, auf dem digitalen Anzeige-Bildschirm (66) befestigt wird, um einen digitalen Anzeige-Bildschirm (1) mit integrierten photovoltaischen Zellen zu bilden.

## Claims

1. A display device (1) with integrated photovoltaic cells, comprising:
(a) an array (3) of image zones (4) emitting light or backlit by a light source (2) placed behind the array (3) of image zones (4);
(b) an array (6) formed by a plurality of photovoltaic cells (7, 8) and a plurality of openings (13) formed between two adjacent photovoltaic cells of said array (6), and;
(c) a lens array (5) that enables focussing the light emitted by said image zones (4) in the opening (13) between two adjacent photovoltaic cells (7, 8), said device (1) being **characterised in that** said lens array (5) is positioned between said array (3) of image zones (4) and said array (6) of photovoltaic cells (7, 8).

2. The display device (1) according to claim 1, **characterised in that** it is a digital display screen.

3. The display device according to claim 2, **characterised in that** it is a flexible screen.

4. The display device (1) according to any one of claims 1 to 3, **characterised in that** said image zones (4) are pixels.

5. The display device (1) according to any one of claims 1 to 4, **characterised in that** said lens array (5) comprises a juxtaposition of identical rectilinear lenses, of which the longitudinal axis is parallel to the strips of photovoltaic cells (7, 8).

6. The display device (1) according to any one of claims 1 to 5, **characterised in that** the lenses of said lens array (5) are selected from the group formed by planoconvex, biconvex, symmetrical, asymmetrical, spherical and/or aspherical lenses, or by lenses with index variation.

7. The display device (1) according to any one of claims 1 to 6, **characterised in that** said array (6) of strips of photovoltaic cells (7, 8) is protected by a protective layer (17), advantageously provided with an anti-reflective layer (11).

8. The display device (1) according to any one of claims 1 to 7, **characterised in that** said photovoltaic cells (7, 8) are thin-film cells based on amorphous or microcrystalline silicon, based on CdTe, or based on CIGS.

9. The display device (1) according to any one of claims 1 to 8, **characterised in that** said photovoltaic cells (7, 8) are at least partially transparent to visible light.

10. The display device (1) according to any one of claims 1 to 9, **characterised in that** said image zones (4), pixels and/or pixel portions are arranged such that different groups of image zones, pixels and/or pixel portions generate different images.

11. The display device (1) according to any one of claims 1 to 10, **characterised in that** it comprises a tactile layer or film on its outer face.

12. The display device (1) according to any one of claims 1 to 11, **characterised in that** it comprises two sets of different photovoltaic cells, one dedicated to photovoltaic conversion of the ambient or external light (20), and the other dedicated to the photovoltaic conversion of the diffusive or internal light originating from the pixels and/or backlighting thereof.

13. The display device (1) according to claim 12, **characterised in that** it comprises a first set of photovoltaic cells disposed on the outer face of the photovoltaic panel and intended to convert the external light, and a second set of photovoltaic cells disposed on the inner face of the photovoltaic panel and intended to convert the internal light.

14. A portable or fixed electronic apparatus incorporating a display device (1) according to any one of claims 1 to 13.

15. A photovoltaic panel with integrated lenses (60) for producing a display device (1) according to any one of claims 1 to 13, comprising a transparent, preferably flexible or semi-rigid, substrate or film (62), said film comprising a lens array (11), and said film comprising an array (5) of photovoltaic cells (7, 8), said photovoltaic cells (7) preferably being protected by at least one continuous or discontinuous protective layer (17) .

16. A method for producing a display screen (1) with integrated photovoltaic cells according to any one of claims 1 to 13, in which a digital display screen (66) comprising a smooth outer surface (63) is provided, and in which a photovoltaic panel with integrated lenses (65) according to claim 15 is provided, and in which said photovoltaic film with integrated lenses (65) is fixed on said digital display screen (66), preferably by gluing, in order to form a digital display screen (1) with integrated photovoltaic cells.
